# EUROPÄISCHE PATENTSCHRIFT

(11) **EP 3 102 535 B1**
(45) Veröffentlichungstag und Bekanntmachung des Hinweises auf die Patenterteilung: **06.06.2018**
(21) Anmeldenummer: 15702744.2
(22) Anmeldetag: 02.02.2015
(51) Int. Cl.: B81C 99/00

(54) **VERFAHREN ZUM HERSTELLEN VON MIKROOBJEKTEN**
METHOD FOR PRODUCING MICRO-OBJECTS
PROCÉDÉ DE FABRICATION DE MICRO-OBJETS

(30) Priorität: 03.02.2014 DE 102014201898
(43) Veröffentlichungstag der Anmeldung: 14.12.2016
(73) Patentinhaber: Universität Kassel, 34125 Kassel (DE)
(72) Erfinder: EHRESMANN, Arno, 66482 Zweibrücken (DE)
(74) Vertreter: SR Huebner - Munich Patentanwaltspartnerschaft mbB
(86) Internationale Anmeldenummer: PCT/EP2015/052076
(87) Internationale Veröffentlichungsnummer: WO 2015/114143

(56) Entgegenhaltungen:
- WO-A1-2011/054391
- DE-A1-102007 051 977

## Beschreibung

### Gebiet der Erfindung

Die Erfindung betrifft ein Verfahren zum Herstellen von Mikroobjekten, bei dem in einem Verfahrensschritt magnetische Mikropartikel durch ein magnetisches Template nach einem vorgegebenen Muster angeordnet und in einer Matrix eingebettet werden. Die Erfindung betrifft außerdem ein Mikroobjekt mit einer Matrix, in die magnetische Mikropartikel eingebettet sind.

### Hintergrund der Erfindung

Die internationale Patentanmeldung WO 2011/054391 A1 und die europäische Patentanmeldung EP 2496354 A1 beschreiben eine Methode und eine Vorrichtung zum Transportieren von magnetischen Flüssigkeiten und Partikeln mithilfe einer magnetischen Schicht, deren Magnetisierung eine Vorzugsrichtung aufweist, die zum Beispiel durch den Exchange Bias-Effekt hervorgerufen wird. Die magnetische Flüssigkeit oder Partikel werden in Streufeldern beispielsweise über Domänenwänden gefangen. Durch Anlegen von externen magnetischen Feldern können die Domänen oder Domänenwände bewegt werden, so dass ein Stofftransport stattfindet.

Die Kombination von flexiblen Polymeren mit eingebetteten magnetischen Nanoobjekten wird von M. Donolato, et al. in "Flexible and Stretchable Polymers with Embedded Magnetic Nanostructures" Adv. Mat. 25 (2013) 623 beschrieben. In einem lithographischen Verfahren werden magnetische Strukturen aus Permalloy auf einer Siliziumoxidschicht hergestellt. Die Siliziumoxidschicht befindet sich auf einer Goldschicht auf einem Siliziumsubstrat. Die magnetische Struktur wird in einer Schicht aus Polydimethylsiloxan (PDMS) eingebettet und dann wird die Siliziumoxidschicht durch Immersion in Wasser von der Goldschicht getrennt.

K. Hatama, et al. beschreiben in "Magnetic Micro Actuator Using Interactive Force between Magnetic Elements" JJAP 51 (2012) 06FL14 zwei Verfahren zum Herstellen eines magnetischen Mikroaktuators. Im ersten Verfahren wird eine Schicht reinen PDMS auf einem Glassubstrat aufgebracht und mit einer zweiten Schicht von PDMS mit gemischt mit Fe-Si Partikeln bedeckt. Mit einem Laser wird die obere Schicht mit den magnetischen Partikeln strukturiert. Bei dem zweiten Verfahren wird zunächst eine Maske photolithographisch strukturiert und dann mit PDMS, das Fe Partikel enthält überzogen, so dass sich das Polymer in die Strukturen einbettet. Überschüssiges Material wird entfernt und eine zweite Schicht von reinem PDMS wird als Trägerschicht aufgebracht. Nach Aushärten des Polymers wird die resultierende Membran abgezogen.

Die deutsche Offenlegungsschrift DE 10 2007 051 977 A1 offenbart ein Verfahren zur Herstellung von elektrisch und/oder magnetisch ansteuerbaren Membranen, sowie einen Aktor der eine solche Membran umfasst zum Einsatz in Schaltern, Pumpen und/oder Ventilen. Bei dem Verfahren werden Mikro- und/oder Nanopartikel mit elektrischen oder magnetischen Eigenschaften mit einem fließfähigen Matrixmaterial vermischt. Die entstandene Dispersion wird dann auf ein Substrat aufgebracht. Anschließend wird durch angelegte elektrische oder magnetische Felder die Konzentration der Partikel lokal geändert, so dass Regionen mit hoher oder geringer Konzentration entstehen. Zum Fixieren der resultierenden Verteilung wird das Matrixmaterial zum Schluss gehärtet.

### Der Erfindung zugrunde liegende Aufgabe

Der Erfindung liegt die Aufgabe zugrunde, ein gegenüber dem Stand der Technik verbessertes Verfahren zum Herstellen von Mikroobjekten anzugeben. Bei dem Verfahren werden in einem Verfahrensschritt magnetische Mikropartikel durch ein magnetisches Template nach einem vorgegebenen Muster angeordnet und in einer Matrix eingebettet. Insbesondere soll ein Verfahren angegeben werden, mit dem aktuierbare Mikroobjekte mit eingebetteten magnetischen Mikropartikeln in Serie gefertigt werden können. Außerdem liegt der Erfindung die Aufgabe zugrunde, ein gegenüber dem Stand der Technik verbessertes aktuierbares Mikroobjekt mit einer Matrix, in die magnetische Mikropartikel eingebettet sind, anzugeben.

### Erfindungsgemäße Lösung

Die Lösung der gestellten Aufgabe gelingt durch Angabe eines Verfahrens zum Herstellen von Mikroobjekten, bei dem in einem Verfahrensschritt magnetische Mikropartikel durch ein magnetisches Template nach einem vorgegebenen Muster angeordnet und in einer Matrix eingebettet werden. Erfindungsgemäß wird eine in Richtung der Dicke der Matrix inhomogene Verteilung der magnetischen Mikropartikel durch inhomogene Streufelder des magnetischen Template erzeugt. Das vorgegebene Muster entsteht dabei durch ein magnetisches Domänenmuster des Template.

Durch die Erfindung können Mikroobjekte hergestellt werden, die durch Anlegen eines externen magnetischen Wechselfeldes aktuierbar sind. Insbesondere kann durch das erfindungsgemässe Verfahren eine Serienfertigung der Mikroobjekte erfolgen.

Mikropartikel im Sinne der Erfindung sind Partikel, die kleiner als 1 mm sind. Der Begriff "Mikropartikel" schließt demnach auch Nanopartikel mit ein, also Partikel, die kleiner als 1 µm sind. Es wird jedoch nicht ausgeschlossen, dass neben den Mikropartikeln auch andere Partikel vorhanden sind. Magnetische Mikropartikel im Sinne der Erfindung sind Mikropartikel, auf die in einem homogenen oder inhomogenen Magnetfeld eine Kraft wirkt. Aus Gründen der Lesbarkeit wird im Folgenden der Begriff "Mikropartikel" verwendet auch wenn "magnetische Mikropartikel" gemeint sind. Geeignete kommerziell erhältliche Mikropartikel sind beispielsweise ferromagnetische, superparamagnetische oder paramagnetische Mikropartikel. Mikropartikel sind erfindungsgemäß in ihrer Form nicht notwendigerweise globulär oder sphärisch, sondern können eine beliebige Form haben. Es kann sich beispielsweise auch um magnetische Nanodrähte oder Nanoröhrchen aus Kohlenstoff handeln, die mit magnetischen Partikeln oder einem Ferrofluid gefüllt sind wie sie zum Beispiel von U. Weisker, et al. in "Carbon Nanotubes Filled with Ferromagnetic Materials" Materials 3 (2010) 4387-4427 beschrieben werden. Weiterhin können magnetische Mikropartikel beispielsweise aus folgenden Materialien bestehen: Fe, Fe₂O₃, Fe₃O₄, FeCoCr-Legierungen, Ni, NiFe, AINiCo, Bariumferrit, Cobalt, CoPt₃, CrO₂, CuNiFe, CuNiCo-Legierungen, SmCo, MnAs, EuO oder Eisenoxid-haltige Pigmente.

Mikroobjekte im Sinne der Erfindung umfassen eine Matrix, in die die Mikropartikel unter Anwendung des erfindungsgemäßen Verfahrens eingebettet werden. Mikroobjekte können beispielsweise als Mikroaktoren verwendet werden. Ein Mikroaktor ist eine Vorrichtung, die ein elektromagnetisches Signal in eine mechanische Größe (zum Beispiel Bewegung oder Druck) umwandelt. Solche Mikroaktoren können beispielsweise als Schalter oder Mikropumpen verwendet werden. Ein erfindungsgemäßes Mikroobjekt kann durch ein magnetisches Feld aktuiert werden, indem die magnetischen Mikropartikel, beziehungsweise deren Magnetisierung, entlang der Feldlinien ausgerichtet werden. Die Wechselwirkung zwischen den magnetischen Mikropartikeln kann dann entweder anziehend oder abstoßend wirken. Dies kann wiederum zu einer mechanischen Verformung des Mikroobjekts führen. Je nach Anordnung der Mikropartikel im Mikroobjekt kann das Mikroobjekt zum Beispiel als Mikroschalter oder Mikropumpe verwendet werden. Anwendung finden können solche Mikroobjekte insbesondere in der Biotechnologie, zum Beispiel zur Steuerung von Flüssigkeiten in einem mikrofluidischen System wie einem "Lab-on-a-Chip", oder in der medizinischen Diagnostik und Therapie, insbesondere im menschlichen Körper. Insbesondere können Mikroaktoren durch die Verformung auch einen Vortrieb in einer Flüssigkeit oder in einem Gas erzeugen. Solche Mikroaktoren können bei Wasserqualitätstests eingesetzt werden. Die Größe eines Mikroobjekts kann zwischen wenigen Mikrometern bis zu einigen Millimetern oder Zentimetern betragen.

Eine Matrix ist ein Trägermaterial zum Einbetten von Mikropartikeln. Ein Mikropartikel ist in der Matrix eingebettet, wenn wenigstens 75% der Oberfläche eines Mikropartikels von der Matrix umschlossen werden. Die Matrix hat die Gestalt einer Membran. Ihre Ausdehnung in zwei Dimensionen ist zumindest lokal wesentlich größer als jene in der dritten dazu senkrechten Dimension. Die Membran kann aus einer oder mehreren Schichten bestehen. Die lokale Dicke der Matrix ist jeweils der in einem Punkt ihrer Oberfläche gemessene kürzeste Abstand zwischen ihrer Ober- und Unterseite. Mindestens eine Schicht der Matrix besteht aus einem Material, in das Mikropartikel verfahrensgemäß nach einem durch ein magnetisches Template vorgegebenen Muster eingebettet werden, so dass diese an ihrer durch das Muster vorgegebenen Position in der Matrix verbleiben und die relative Lage der Mikropartikel im Wesentlichen nur durch Verformung der Matrix veränderlich ist. Die Matrix dient somit auch als strukturgebendes Verbundmaterial der Mikroobjekte. Erfindungsgemäß werden die Mikropartikel bezogen auf die Dicke der Matrix inhomogen verteilt. Das heißt, dass ein Großteil von wenigstens 55%, vorzugsweise 60%, besonders vorzugsweise 70%, nochmals besonders vorzugsweise 80%, 90% oder 95% der Mikropartikel in einer auf die Dicke der Matrix bezogenen Hälfte der Matrix eingebettet werden. Insbesondere ist der Großteil der Mikropartikel in der dem magnetischen Template zugewandten Hälfte der Matrix eingebettet. Hierdurch kann der Vorteil erreicht werden, dass die elastischen Eigenschaften des Matrixmaterials nur geringfügig durch die Mikropartikel beeinflusst werden. Die Matrix kann beispielsweise aus einer oder mehreren Schichten folgender Materialien bestehen: Silikone oder thermoplastische Elastomere, Epoxidharze, Polyamide, Polyimide, PDMS oder andere Polymere auf Siliziumbasis.

Ein magnetisches Template (im Folgenden auch einfach als "Template" bezeichnet) ist eine Struktur, von der magnetische Felder in einem vorgegebenen Muster (ein künstliches oder natürliches magnetisches Domänenmuster) ausgehen. Das Template kann außerdem die geometrische Form der Mikroobjekte bestimmen, indem vorzugsweise die Matrix die geometrische Form des Templates annimmt, wobei vorzugsweise ein Gussverfahren angewendet wird. Das Muster der magnetischen Felder des magnetisches Templates kann beispielsweise in einer Schicht mit Exchange Bias durch keV-He+ lonenbombardierung präpariert werden wie zum Beispiel von Holzinger et al. in "Tailored domain wall charges by individually set in-plane magnetic domains for magnetic field lanscape design" Journal of Applied Physics 114 (2013) 013908 und den dort aufgelisteten Referenzen beschrieben wird. Dazu besteht ein Template beispielsweise aus einem topographisch ebenen Substrat, beispielsweise aus Silizium, auf dem eine oder mehrere magnetische Schichten, beispielsweise durch Aufdampfen oder Sputtering, angeordnet sind. Im Allgemeinen kann das Template eine beliebige Oberflächengeometrie aufweisen.

Die Aufgabe wird außerdem gelöst durch ein Mikroobjekt mit einer Matrix, in die magnetische Mikropartikel nach einem vorgegebenen Muster eingebettet sind. Erfindungsgemäß ist die Matrix gewölbt, wenn keine äußeren Kräfte auf das Mikroobjekt einwirken. Ein Mikroobjekt mit einer gewölbten Matrix hat den erreichbaren Vorteil, dass bei entsprechender Anordnung der Mikropartikel in Kombination mit einer inneren Spannung der Matrix ein Mikroaktor realisiert werden kann, der durch Anlegen eines äußeren magnetischen Wechselfeldes bei Einsatz in einer Flüssigkeit oder einem Gas ein Vortrieb erzeugt werden kann.

### Bevorzugte Ausgestaltungen der Erfindung

Vorteilhafte Aus- und Weiterbildungen, welche einzeln oder in Kombination miteinander eingesetzt werden können, sind Gegenstand der abhängigen Ansprüche.

Bei dem erfindungsgemäßen Verfahren wird die inhomogene Verteilung der magnetischen Mikropartikel in Richtung der Dicke der Matrix durch das magnetische Template erzeugt, und das magnetische Template erzeugt die inhomogene Verteilung der Mikropartikel durch inhomogene magnetische Streufelder. Vorzugsweise werden die magnetischen Partikel bevorzugt auf einer dem magnetischen Template zugewandten Seite der Matrix angeordnet. Bevorzugte magnetische Templates zum Erzeugen inhomogener magnetischer Streufelder werden durch "light-ion bombardment induced magnetic patterning" erzeugt (IBMP), beschrieben zum Beispiel in: J. Fassbender, et al., "Magnetization Reversal of Exchange Bias Double Layers Magnetically Patterned by Ion Irradiation" Phys. Stat. Sol. (a) 189 (2002) 439; A. Ehresmann, et al, "He-ion bombardment induced exchange bias modifications: Fundamentals and applications" Recent Res. Devel. Applied. Phys. 7 (2004) 401-421; A. Ehresmann, et al. "He-ion bombardment induced exchange bias modifications: Fundamentals and applications" J. Phys. D 38 (2005) 801-806; oder A. Mougin, et al. "Magnetic micropatterning of FeNi/FeMn exchange bias bilayers by ion irradiation" J. Appl. Phys. 89 (2001) 6606-6608. Der erreichbare Vorteil eines solchen Templates ist, dass die magnetischen Muster Strukturgrößen von weniger als 1 µm, vorzugsweise weniger als 0,1 µm, besonders vorzugsweise weniger als 0,01 µm aufweisen können. In einem alternativen Verfahren werden Templates mit einem magnetischen
Granatfilm verwendet (siehe zum Beispiel: L. E. Helseth, et al. "Magnetic structuring and transport of colloids at interfaces" J. Magn. Mat. 277 (2004) 245-250). In einem weiteren alternativen Verfahren werden Templates mit Arrays topographischer Mikromagneten verwendet (siehe zum Beispiel: B. Yellen, et al. "Programmable Assembly of Heterogeneous Colloidal Particle Arrays" Adv. Mater. 16 (2004) 111-115; K. Gunnarsson,et al. "Programmable Motion and Separation of Single Magnetic Particles on Patterned Magnetic Surfaces" Adv. Mater. 17 (2005) 1730; B. Yellen, et al. "Arranging matter by magnetic nanoparticle assemblers" Proc. Natl. Acad. Sci. USA 102 (2005) 8860; B. Yellen, et al. "Traveling wave magnetophoresis for high resolution chip based separations" Lab Chip 7 (2007) 1681).

Bei einem bevorzugten Verfahren werden die magnetischen Mikropartikel in einem weiteren Verfahrensschritt in der Matrix fixiert. Vorzugsweise werden die auf dem Template angeordneten Mikropartikel zunächst in dem Material, das die Matrix bildet, eingegossen. Dazu bedient sich ein bevorzugtes Verfahren eines fließfähigen Matrixmaterials. Besonders vorzugsweise lässt sich das fließfähige Matrixmaterial in einem weiteren Verfahrensschritt aushärten. Vorzugsweise fixiert das Aushärten die Position der Mikropartikel in der Matrix. In einer alternativen Form des Verfahrens werden die Mikropartikel zunächst mit dem Matrixmaterial vermischt. Vorzugsweise ist das Matrixmaterial flüssig. Dies hat den erreichbaren Vorteil, dass die Mikropartikel im Matrixmaterial weitgehend frei beweglich sind. Vorteilhafterweise richten sich die mit dem Matrixmaterial vermengten Mikropartikel nach Auftragen des Matrixmaterials entsprechend des magnetischen Musters des Templates aus. Vorzugsweise ist die Viskosität des Matrixmaterials so niedrig, dass es durch einfaches Aufträufeln, beispielsweise mit einer Pipette, auf das Template aufgetragen werden kann. In einer weiteren bevorzugten Methode wird das Matrixmaterial mit einem Squeegee-Verfahren aufgetragen. Eine alternative Methode zum Auftragen des Matrixmaterials ist ein Spin-Coating-Verfahren. In einer weiteren alternativen Ausführung wird das Matrixmaterial mit einem Pinsel auf dem Template aufgetragen. Alternativ kann das Matrixmaterial auch zwischen dem magnetischen Template und einem zweiten formgebenden Element gepresst werden, so dass die Schichtdicke des Matrixmaterials durch den Aufpressdruck kontrolliert werden kann. Eine weitere bevorzugte Methode zum Auftragen des Matrixmaterials ist das Eintauchen des Templates in einen Behälter, der mit dem flüssigen Matrixmaterial gefüllt ist. Weitere bevorzuge Methoden zum Auftragen des Matrixmaterials sind Aufschleudern, Aufrakeln, Gießen oder Sprühen. Auf die Schicht des Matrixmaterials, das Mikropartikel enthält, können auch noch weitere Schichten desselben oder eines anderen Matrixmaterials ohne Mikropartikel aufgetragen werden. Vorzugsweise weist das Template eine Oberfläche zum Auftragen des Matrixmaterials auf, die ein Entfernen des fertigen Mikroobjekts erleichtert. Besonders vorzugsweise wird durch das Auftragen und das Entfernen der Matrix die magnetische Eigenschaft des Templates nicht verändert.

Bei einem bevorzugten Verfahren wird ein Polymer zur Bildung der Matrix verwendet. Ein bevorzugtes Polymer wird in einem fließfähigen Zustand auf das magnetische Template aufgebracht. Vorzugsweise ist die Viskosität des Polymers kleiner als 5000 mPa s (1 mPa s = 10⁻³ N s/m²), besonders vorzugsweise kleiner als 1000 mPa s, nochmals besonders vorzugsweise kleiner als 500 mPa s, nochmals besonders vorzugsweise kleiner als 100 mPa s. Es ist bevorzugt, dass das Polymer nach Auftragen auf das Template zum Fixieren der Mikropartikel ausgehärtet wird, zum Beispiel indem eine Vernetzungsreaktion induziert wird. Vorzugsweise lässt sich das Polymer mit UV-Licht aushärten, besonders vorzugsweise durch Erhitzen, nochmals besonders vorzugsweise härtet das Polymer bei Raumtemperatur aus. In einem alternativen Verfahren wird ein Polymer verwendet, das durch Mischen mit einer zweiten Komponente aushärtet. Vorzugsweise ist die zweite Komponente ein Stoff, der das Polymer durch eine chemische Reaktion polymerisieren lässt. Vorteilhafterweise ist das Polymer nach Aushärten elastisch und/oder verformbar. Polymere sind sehr vielfältige Werkstoffe, deren physikalische und chemische Eigenschaften sehr unterschiedlich sein können. Vorteilhafterweise kann somit ein Polymer mit den für die gewünschte Anwendung geeigneten Eigenschaften ausgewählt werden. Bevorzugt ist ein Polymersystem zu verwenden, das bei Anwendung in lebenden Organismen, beispielsweise bei Menschen und Tieren, chemisch inert ist. Ein bevorzugtes Polymersystem ist Polydimethylsiloxan (PDMS). Verwendung von PDMS hat den erreichbaren Vorteil, dass die damit hergestellten Mikroobjekte auch im menschlichen (oder tierischen) Körper zur Anwendung kommen können ohne unerwünschte biologische oder chemische Reaktionen auszulösen. Alternativ können aber auch zum Beispiel Epoxidharze als Polymersystem verwendet werden.

Bei einem bevorzugten Verfahren wird ein Matrixmaterial verwendet, dessen Elastizitätsmodul kleiner als 2 MPa (1 MPa = 10⁶ Pa) ist. Wird ein Matrixmaterial verwendet, dass zum Fixieren der Mikropartikel ausgehärtet wird, zum Beispiel ein Polymer, so bezieht sich der angegebene Elastizitätsmodul auf das gehärtete Matrixmaterial. Vorzugsweise ist der Elastizitätsmodul des Matrixmaterials kleiner als oder gleich 1 MPa, besonders vorzugsweise kleiner als 0,5 MPa, nochmals besonders vorzugsweise kleiner als 0,1 MPa. Durch Verwenden eines Matrixmaterials mit einem kleinen Elastizitätsmodul, kann eine Kontraktion und/oder Ausdehnung des Mikroobjekts erreicht werden. Vorzugsweise beträgt die erreichbare Längenänderung pro 100 µm Länge des Mikroobjekts mehr als 10 nm, besonders vorzugsweise mehr als 100 nm bei Anlegen eines Magnetfelds. Da die Kontraktion und/oder Ausdehnung vorteilhafterweise nur in einer äußeren Grenzschicht des Mikroobjekts auftritt, kann das Mikroobjekt hierdurch verformt, beispielsweise verbogen werden. In einem alternativen Verfahren wird ein Matrixmaterial verwendet dessen Elastizitätsmodul größer als 1 MPa, vorzugsweise größer als 5 MPa, besonders vorzugsweise größer als 10 MPa ist.

Bei einem bevorzugten Verfahren wird die Matrix in einer Dicke von weniger als 1 mm gebildet. Vorzugsweise wird die Matrix gebildet, indem eine Schicht des Matrixmaterials auf das Template aufgetragen wird. Vorzugsweise beträgt die Dicke der Matrix weniger als 0,1 mm, besonders vorzugsweise weniger als 0,05 mm, nochmals besonders vorzugsweise weniger als 0,01 mm. Vorzugsweise ist die Dicke der Matrixschicht im Wesentlichen konstant über der gesamten Oberfläche des Templates. Besonders vorzugsweise variiert die Schichtdicke weniger als 10% bezogen auf die mittlere Schichtdicke. In einer bevorzugten Ausführung ist die Schichtdicke von der gleichen Größenordnung, also ein bis zehn mal so dick, wie die mittlere Partikelgröße, besonders vorzugsweise ist die Schicht doppelt so dick wie die mittlere Partikelgröße, nochmals besonders vorzugsweise drei mal so dick. In einer alternativen Ausführung kann die Schichtdicke auch mehr als zehn Mal so groß sein wie die mittlere Größe der Mikropartikel. Vorzugsweise ist die Matrixschicht bis zu 100 Mal, besonders vorzugsweise bis zu 1000 Mal so dick wie die Mikropartikel.

In einem bevorzugten Verfahren werden die magnetischen Mikropartikel in einem regelmäßigen Muster angeordnet. Das Muster ergibt sich vorzugsweise aus einem entsprechenden Muster von magnetischen Streufeldern des Templates, in dem die magnetischen Mikropartikel eingefangen und angeordnet werden. Ein bevorzugtes Muster besteht aus geradlinigen, vorzugsweise parallelen Reihen mit einem vorzugsweise regelmäßigen Abstand. Ein alternatives bevorzugtes Muster besteht aus Ringen, die vorzugsweise kreisförmig sind und besonders vorzugsweise konzentrisch angeordnet sind. Ein weiteres alternatives Muster ist sternförmig. Vorzugsweise besteht ein sternförmiges Muster aus von einem gemeinsamen Zentrum, strahlenförmig radial nach außen gerichteten Strecken. Vorzugsweise sind die Strahlen gerade. In einer alternativen Ausführung sind die Strahlen gekrümmt, so dass vorzugsweise ein wirbelförmiges Muster entsteht.

Es ist bevorzugt, dass das magnetische Template durch das Verfahren nicht verbraucht wird. Dass das Template nicht verbraucht wird heißt, dass die physikalischen, insbesondere die magnetischen Eigenschaften des Templates durch das Verfahren nicht verändert werden. Vorzugsweise werden Betrag und Richtung der Streufelder und/oder die Magnetisierung des magnetischen Templates durch das Verfahren nicht verändert. Besonders vorzugsweise wird das Template durch das Verfahren auch nicht in seinen mechanischen Eigenschaften durch das Verfahren verändert. Hiermit ist der Vorteil erreichbar, dass das Template zur Serienproduktion von Mikroobjekten geeignet ist. Das bedeutet, dass mit demselben Template vorzugsweise wenigstens zehn Mikroobjekte mit gleich bleibenden Eigenschaften hergestellt werden können, besonders vorzugsweise wenigstens 100 Mikroobjekte, nochmal besonders vorzugsweise wenigstens 1000. Ein solches Verfahren erlaubt vorteilhafter Weise die Serienfertigung von Mikroobjekten in großen Stückzahlen.

In einem bevorzugten Verfahren wird ein magnetisches Template verwendet, das gewölbt ist. Gewölbt im Sinne der Erfindung heißt, dass die Oberfläche des Templates auf der die Mikropartikel angeordnet werden nicht eben ist. Eine bevorzugte Wölbung hat im Querschnitt ein D-förmiges Profil. Vorzugsweise sind die Höhenlinien eines bevorzugten gewölbten Templates parallel zueinander. In einer weiteren bevorzugten Ausführung hat ein gewölbtes Template Höhenlinien, die konzentrische Kreise oder nicht-kreisförmige Ringe sind. In einer anderen bevorzugten Ausführung hat die Oberfläche des Template die Form eines Kugelabschnitts. In einer alternativen Ausführung, wird die Oberfläche des Templates durch eine zweidimensionale Gauß-Funktion beschrieben. In weiteren bevorzugten Ausführungen wird die Oberfläche des Templates durch Rotation einer Funktion um eine Achse beschrieben. Vorteilhafterweise können mit einem gewölbten Template Mikroobjekte hergestellt werden, die mindestens eine gewölbte Oberfläche aufweisen.

In einem bevorzugten Verfahren werden superparamagnetische Mikropartikel verwendet, beispielsweise nanopartikuläre Eisenoxidpartikel in wässriger Suspension. Superparamagnetische Mikropartikel haben auch unterhalb der Curie-Temperatur keine bleibende Magnetisierung. Vorteilhafterweise bilden superparamagnetische Mikropartikel keine Cluster, da sie untereinander wenn überhaupt nur sehr schwach wechselwirken. Superparamagnetische Mikropartikel sind so klein, dass sie vorzugsweise nur eine einzige magnetische Domäne ausbilden. Es ist bevorzugt, dass die verwendeten Mikropartikel kleiner als 100 µm sind, besonders vorzugsweise kleiner als 10 µm, nochmals besonders vorzugsweise kleiner als 1 µm, nochmals besonders vorzugsweise kleiner als 0,1 µm, nochmals besonders vorzugsweise kleiner als 0,01 µm.

Bei einem bevorzugten Verfahren geschieht das Anordnen der magnetischen Mikropartikel auf dem magnetischen Template in einer Flüssigkeit. Die Flüssigkeit dient vorteilhafterweise zum Transport der Mikropartikel. Vorzugsweise ermöglicht die Flüssigkeit, dass sich die Mikropartikeln weitestgehend frei bewegen können. Vorzugsweise finden keine oder fast keine chemische Reaktionen zwischen der Flüssigkeit und den Mikropartikeln statt.

Vorzugsweise werden die magnetischen Mikropartikel zunächst mit einer Flüssigkeit vermischt. In einem bevorzugten Verfahren wird die Flüssigkeit auf das Template gebracht, zum Beispiel unter Verwendung einer Pipette auf das Template getropft. Vorteilhafterweise ordnen sich die magnetischen Mikropartikel selbstständig, das heißt ohne weiteres Einwirken von außen, nach dem vorgegebenen Muster auf dem Template an. Vorzugsweise enthält die auf das Template aufgebrachte Menge der Flüssigkeit ein Vielfaches der Anzahl der Mikropartikel, die durch die magnetische Wechselwirkung mit dem Template auf diesem fixiert werden. Somit kann vorteilhafterweise erreicht werden, dass die maximale Anzahl von Mikropartikeln auf dem Template angeordnet wird. Die Bereiche des Templates, in denen Mikropartikel durch magnetische Wechselwirkung eingefangen werden können sind daher gesättigt. Vorzugsweise werden überzählige, nicht fixierte Mikropartikel durch Spülen mit einer Flüssigkeit, die keine Mikropartikel enthält entfernt. Eine bevorzugte Flüssigkeit ist polar, besonders vorzugsweise ist die Flüssigkeit Wasser, nochmals besonders vorzugsweise destilliertes Wasser. Vorzugsweise liegen die Mikropartikel in wässriger Suspension vor. Alternativ kann auch eine unpolare Flüssigkeit verwendet werden, wie zum Beispiel ein Öl. In einer weiteren bevorzugten Ausführung ist die Flüssigkeit das Matrixmaterial, das sich vorzugsweise durch einen weiteren Verfahrensschritt aushärten lässt. Weiterhin ist eine bevorzugte Flüssigkeit benetzend, besonders vorzugsweise mit einem Kontaktwinkel kleiner als 90° bezogen auf einen Vollkreis von 360°. Eine bevorzugte Flüssigkeit ist außerdem flüchtig, so dass sie sich vorteilhafterweise nach dem Positionieren der Mikropartikel durch Verdampfen vom Template verflüchtigt. Beispielsweise kann Ethanol verwendet werden. Vorteilhafterweise ermöglicht das Positionieren der Mikropartikel in einer Flüssigkeit, dass die Mikropartikel mobil genug sind, um sich auf dem Template auszurichten und anzuordnen. In einem weiteren bevorzugten Verfahren wird das Template in die Flüssigkeit mit den Mikropartikeln eingetaucht, wobei sich die Mikropartikel dann vorzugsweise selbstständig, also ohne weiteres Einwirken von außen entsprechend der magnetischen Felder des Templates anordnen. Vorzugsweise verdampft die Flüssigkeit nachdem sich die Partikel positioniert haben vollständig. Ein erreichbarer Vorteil der Flüssigkeit ist außerdem, dass sie ein Aneinanderhaften und/oder Haufenbildung der Mikropartikel weitestgehend oder gänzlich verhindert oder wenigstens vermindert.

In einem bevorzugen Verfahren lagern sich die magnetischen Mikropartikel in Bereichen hoher magnetischer Streufelddichte auf dem Template an. Vorzugsweise lagert sich ein überwiegender Anteil der Mikropartikel in Bereichen hoher Streufelddichte an. Besonders vorzugsweise treten die Bereiche hoher Streufelddichte an den Domänenwänden des magnetischen Templates auf. Vorzugsweise sind die Streufelder stark inhomogen. Vorzugsweise beträgt die Feldstärke der Streufelder unmittelbar über der Oberfläche des Templates wenigstens 0.01 kA/m, besonders vorzugsweise wenigstens 0.1 kA/m, nochmals besonders vorzugsweise wenigstens 1 kA/m.

Es ist bevorzugt, dass das Mikroobjekt im Wesentlichen die Form eines Rotationskörpers aufweist. Ein bevorzugtes Mikroobjekt hat im Wesentlichen die Form einer halben Kugelschale. Bei einem bevorzugten Mikroobjekt sind die Mikropartikel bezogen auf die Dicke der Matrix inhomogen verteilt. Vorzugsweise ist die Matrix aus einem Polymer. Ein bevorzugtes Polymer ist PDMS. Die Dicke der Matrix eines bevorzugten Mikroobjekts ist kleiner als 1 mm, vorzugsweise kleiner als 0,5 mm besonders vorzugsweise kleiner als 0,1 mm, nochmals besonders vorzugsweise kleiner als 0,01 mm, nochmals besonders vorzugsweise kleiner als 0,01 mm aber größer oder gleich 0,005 mm. Es ist bevorzugt, dass die Mikropartikel in einem regelmäßigen Muster in der Matrix des Mikroobjekts angeordnet sind. Ein bevorzugtes regelmäßiges Muster besteht aus Streifen, die vorzugsweise Parallel sind. Ein alternatives Muster besteht aus Ringen, die vorzugsweise konzentrisch angeordnet sind. Bevorzugte Mikroobjekte enthalten superparamagnetische Mikropartikel.

Es ist bevorzugt, dass der Elastizitätsmodul der Matrix kleiner als 2 MPa ist. Besonders vorzugsweise ist der Elastizitätsmodul kleiner als 1 MPa, nochmals besonders vorzugsweise kleiner als 0,5 MPa. Hierdurch kann vorteilhafterweise erreicht werden, dass sich das Mikroobjekt bei Anlegen eines Magnetfeldes reproduzierbar ausdehnt und/oder zusammenzieht.

Vorzugsweise ist der Volumenanteil der Mikropartikel in einem bevorzugten Mikroobjekt kleiner als 25%, besonders vorzugsweise kleiner als 15%, nochmals besonders vorzugsweise kleiner als 5%. Vorteilhafterweise kann somit ein Mikroobjekt realisiert werden, dessen Elastizitätsmodul kaum oder nur geringfügig durch die Mikropartikel beeinflusst wird.

### Kurzbeschreibung der Zeichnungen

- Fig. 1: Figur 1 zeigt eine schematische Illustration des erfindungsgemäßen Verfahrens.
- Fig. 2: Figur 2 zeigt eine schematische Illustration einer alternativen Ausführung des erfindungsgemäßen Verfahrens.
- Fig. 3: Figur 3 zeigt eine schematische Darstellung eines Mikroobjekts in Schnittansicht in einem magnetischen Wechselfeld.

Weitere vorteilhafte Ausgestaltungen werden nachfolgend anhand eines in den Zeichnungen dargestellten Ausführungsbeispiels, auf welches die Erfindung jedoch nicht beschränkt ist, näher beschrieben.

### Ausführliche Beschreibung der Erfindung anhand von einem Ausführungsbeispiel

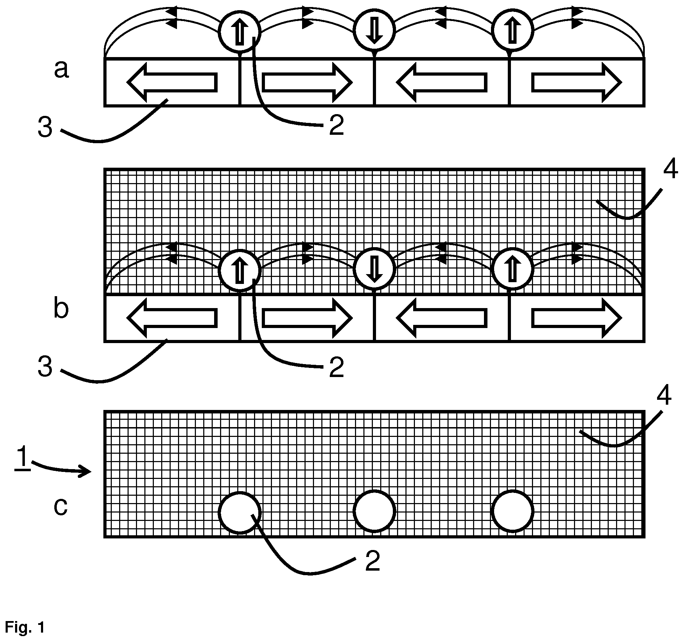

Figur 1 illustriert eine beispielhafte Ausführung des erfindungsgemäßen Verfahrens zum Herstellen von Mikroobjekten 1, bei dem magnetische Mikropartikel 2 nach einem durch ein magnetisches Template 3 vorgegebenen Muster in einer Matrix 4 eingebettet werden. In Figur 1a ist ein Ausschnitt einer magnetisch strukturierten Schicht eines im Wesentlichen topographisch flachen magnetischen Templates 3 in einer schematischen Darstellung in Schnittansicht zu sehen. Das magnetische Muster der Schicht wurde erzeugt, indem die Magnetisierungsrichtung (angedeutet durch Pfeile) der magnetischen Domänen durch Beschuss mit Ionen ausgerichtet wurde (IBMP). Das gezeigte Template 3 weist ein Streifenmuster der magnetischen Domänen auf, wobei die einzelnen Streifen eine Breite von 50 µm aufweisen. Typischerweise können mit der IBMP-Methode Streifen mit einer Breite zwischen 0,5 µm und 1000 µm hergestellt werden. Die Pfeile deuten die Magnetisierungsrichtung der Streifen an, die hier in der Ebene des Templates 3 liegen. Die gekrümmten Linien illustrieren die magnetischen Feldlinien. An den Grenzen zwischen den Streifen, den sogenannten Domänenwänden, treten schwache aber sehr inhomogene magnetische Felder auf, in denen magnetische Mikropartikel 2 eingefangen werden können. Die Mikropartikel 2, zum Beispiel superparamagnetische Mikrokügelchen mit einem mittleren Durchmesser von 2 µm. Die magnetischen Mikropartikel 2 werden in wässriger Suspension auf das Template 3 gebracht. Somit sind sie mobil genug um sich im Wesentlichen selbstorganisiert entlang der Domänenwände anzuordnen, wo die Streufelder am größten sind. Das durch das magnetische Template 3 induzierte magnetische Moment (illustriert durch Pfeile) der Mikrokügelchen wurde experimentell gemessen und beträgt zwischen 10⁻¹⁴ A m² und 10⁻¹³ A m² bei einer magnetischen Feldstärke von etwa 0,1 kA/m an der Oberfläche des Templates 3. Die Dichte der Mikrokügelchen ist in Richtung parallel zu den Streifen sehr groß, so dass der mittlere Abstand zwischen zwei benachbarten Mikrokügelchen typischerweise zwischen 0,1 µm und 1 µm liegt. Das durch das magnetische Template 3 in den Mikrokügelchen induzierte magnetische Moment ist sehr klein, so dass die Abstoßung zwischen benachbarten Mikrokügelchen (mit parallelen magnetischen Momenten) vernachlässigbar gering ist. Der resultierende mittlere Abstand zwischen zwei benachbarten Mikrokügelchen beträgt in etwa 0,1 µm bis 1 µm.

Nachdem sich die Mikropartikel 2 selbstorganisiert auf dem Template 3 angeordnet haben, wird das Template 3 in einem optionalen Verfahrensschritt mit Waser gespült, um eventuell vorhandene überschüssige Mikropartikel 2 zu entfernen. Die Fließgeschwindigkeit des Spülwassers ist dabei so gering, dass im Wesentlichen keine durch Streufelder gefangenen Mikropartikel 2 mitgerissen werden. Anschließend wird das noch auf dem Template vorhandene Wasser durch Verdampfen entfernt. Übrig bleiben nur die auf dem Template 3 angeordneten Mikropartikel 2 wie in Fig. 1a gezeigt. In einem weiteren Verfahrensschritt wird ein flüssiges Polymer in einer dünnen Schicht von etwa 20 µm auf dem Template aufgetragen, so dass eine Anordnung wie in Fig. 1b entsteht. Entlang der Dicke der Matrix 4 sind die Mikropartikel 2 inhomogen verteilt. Sie sind nahezu ausschließlich in der dem Template 3 zugewandten Hälfte der Matrix 4 angeordnet. Anschließend wird UV-Licht auf die Matrix eingestrahlt, wodurch die Vernetzung des Polymers in Gang gebracht wird, so dass das Polymer ausgehärtet. Das ausgehärtete Polymer weist einen Elastizitätsmodul von etwa 1 MPa auf. Im ausgehärteten Zustand lässt sich das fertige Mikroobjekt 1 mit einer Pinzette vom Template 3 abziehen. Nach Abziehen des Mikroobjekts 1 von dem magnetischen Template 3 kann das Verfahren wiederholt und ein weiteres Mikroobjekt 1 mit dem gleichen Template 3 hergestellt werden.

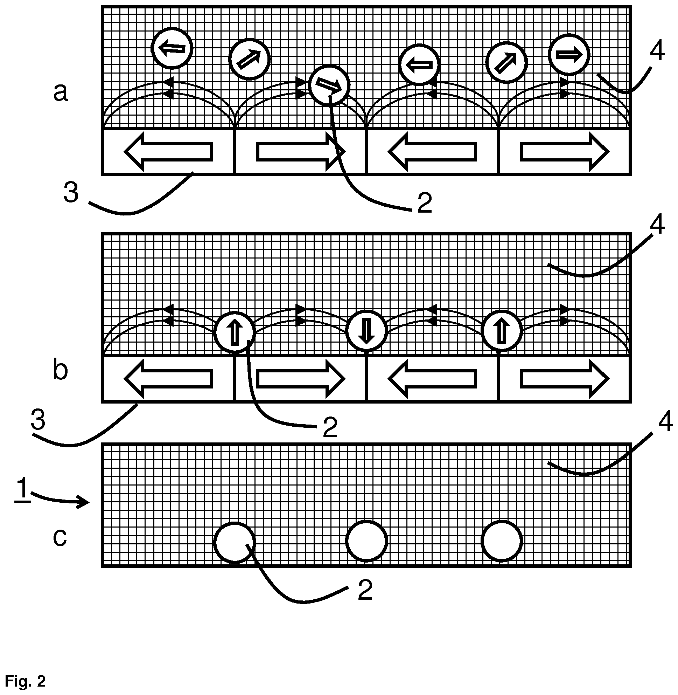

In Fig. 2 ist eine alternative Ausführung des erfindungsgemäßen Verfahrens illustriert. In diesem Verfahren wird das Matrixmaterial 4, dem magnetische Mikropartikel 2 beigemischt sind, auf das Template 3 aufgetragen. In Fig. 2a ist eine anfängliche zufällige, im Wesentlichen homogene Verteilung der Mikropartikel 3 im Matrixmaterial 4 zu sehen. Durch die Krafteinwirkung der magnetischen Streufelder des Templates 3 ordnen sich die Mikropartikel 2 nahe der Oberfläche des Templates 3 an wie in Fig. 2b gezeigt ist. Nach Aushärten des Matrixmaterials 4 kann das fertige Mikroobjekt 1 vom Template 3 entfernt werden.

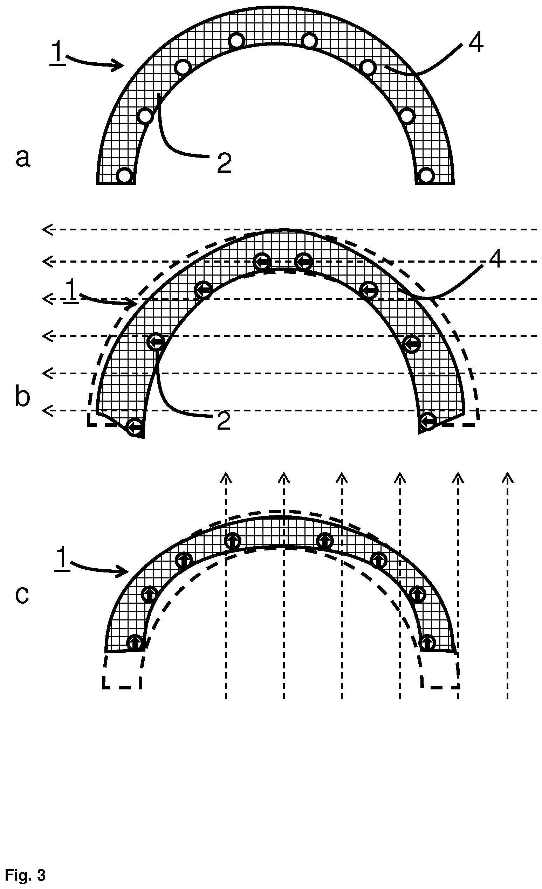

Das in Fig. 3 im Schnitt dargestellte Mikroobjekt 1 wurde mit dem erfindungsgemäßen Verfahren hergestellt und besteht aus einer Matrix 4, die die Form einer halben Kugelschale aufweist, in die superparamagnetische Mikropartikel 2 eingebettet sind. Die Mikropartikel 2 sind in konzentrisch um den Scheitelpunkt des Mikroobjekts 1 verlaufenden Ringen angeordnet. In Fig. 3a ist die Grundform des Mikroobjekts 1 in Schnittansicht dargestellt wenn keine äußere Kraft auf das Mikroobjekt 1 einwirkt. Fig. 3b und 3c illustrieren, wie sich die Form ändert wenn ein magnetisches Wechselfeld angelegt wird, dabei ist gestrichelt zum Vergleich jeweils die Grundform aus Fig. 3a hinterlegt. Die gestrichelten Pfeile deuten die Richtung des angelegten Magnetfelds an. In Fig. 3b richtet das externe Magnetfeld die Magnetisierung der Mikropartikel 2 in horizontaler Richtung aus. Da sich gleichartige Pole abstoßen und gegensätzliche Pole anziehen, wird die Matrix 4 des Mikroobjekts 1 am Scheitelpunkt komprimiert und an den Rändern ausgedehnt. Fig. 3c zeigt das Mikroobjekt 1 bei Verlauf der Magnetfeldlinien in senkrechter Richtung. Nun stoßen sich die Mikropartikel 2 die am Scheitel eingebettet sind aufgrund ihrer Polarisierung gegenseitig ab und führen zu einer Ausdehnung des elastischen Matrixmaterials 4. An den Rändern hingegen ziehen sie einander an. Dies führt wiederum zu einer Änderung der Form des Mikroobjekts 1. Im weiteren Verlauf der Oszillation des magnetischen Feldes drehen sich die Magnetfeldlinien weiter im Uhrzeigersinn, so dass sich die Verformung des Mikroobjekts periodisch wiederholt. Hierdurch wird eine peristaltische Bewegung des Mikroobjekts bewirkt. Bei Anwendung beispielsweise in einer Flüssigkeit, in der das Mikroobjekt schwebt, könnte dies zu einem Vortrieb führen. Das Mikroobjekt würde sich ähnlich wie eine Qualle bewegen.

Die in der vorstehenden Beschreibung, den Ansprüchen und den Zeichnungen offenbarten Merkmale können sowohl einzeln als auch in beliebiger Kombination für die Verwirklichung der Erfindung in ihren verschiedenen Ausgestaltungen von Bedeutung sein.

### Bezugszeichenliste

- 1.: Mikroobjekt
- 2.: Mikropartikel
- 3.: Magnetisches Template
- 4.: Matrix

## Patentansprüche

1. Verfahren zum Herstellen von Mikroobjekten (1), bei dem in einem Verfahrensschritt magnetische Mikropartikel (2) durch ein magnetisches Template (3) nach einem vorgegebenen Muster angeordnet und in einer Matrix (4) eingebettet werden,
**dadurch gekennzeichnet, dass**
eine in Richtung der Dicke der Matrix (4) inhomogene Verteilung der magnetischen Mikropartikel (2) durch inhomogene Streufelder des magnetischen Template (3) erzeugt wird,
wobei das vorgegebene Muster durch ein magnetisches Domänenmuster des Template (3) entsteht.

2. Verfahren nach Anspruch 1,
**dadurch gekennzeichnet, dass**
in einem weiteren Verfahrensschnitt die Matrix (4) vom magnetischen Template (3) abgelöst wird.

3. Verfahren nach einem der vorhergehenden Ansprüche,
**dadurch gekennzeichnet, dass**
in einem weiteren Verfahrensschritt die magnetischen Mikropartikel (2) in der Matrix (4) fixiert werden.

4. Verfahren nach einem der vorhergehenden Ansprüche,
**dadurch gekennzeichnet, dass**
zum Bilden der Matrix (4) ein Polymer verwendet wird.

5. Verfahren nach einem der vorhergehenden Ansprüche,
**dadurch gekennzeichnet, dass**
ein Matrixmaterial mit einem Elastizitätsmodul kleiner als 2 MPa verwendet wird.

6. Verfahren nach einem der vorhergehenden Ansprüche,
**dadurch gekennzeichnet, dass**
die Matrix (4) in einer Dicke von weniger als 1 mm gebildet wird.

7. Verfahren nach einem der vorhergehenden Ansprüche,
**dadurch gekennzeichnet, dass**
die magnetischen Mikropartikel (2) in einem regelmäßigen Muster angeordnet werden.

8. Verfahren nach einem der vorhergehenden Ansprüche,
**dadurch gekennzeichnet, dass**
das magnetische Template (3) durch das Verfahren nicht verbraucht wird.

9. Verfahren nach einem der vorhergehenden Ansprüche,
**dadurch gekennzeichnet, dass**
das magnetische Template (3) gewölbt ist.

10. Verfahren nach einem der vorhergehenden Ansprüche,
**dadurch gekennzeichnet, dass**
superparamagnetische Mikropartikel (2) verwendet werden.

11. Verfahren nach einem der vorhergehenden Ansprüche,
**dadurch gekennzeichnet, dass**
das Anordnen der magnetischen Mikropartikel (2) auf dem magnetischen Template (3) in einer Flüssigkeit geschieht.

12. Verfahren nach einem der vorhergehenden Ansprüche,
**dadurch gekennzeichnet, dass**
sich die magnetischen Mikropartikel (2) in Bereichen hoher magnetischer Streufelddichte auf dem Template (3) anlagern.

13. Mikroobjekt (1) hergestellt nach dem Verfahren vom Anspruch 1 mit einer Matrix (3), in die magnetische Mikropartikel (2) nach einem vorgegebenen Muster eingebettet sind,
**dadurch gekennzeichnet, dass**
die Matrix (3) gewölbt ist, wenn keine äußeren Kräfte auf das Mikroobjekt (1) einwirken.

14. Mikroobjekt (1) nach Anspruch 13, **dadurch gekennzeichnet, dass** der Elastizitätsmodul der Matrix (3) kleiner als 2 MPa ist.

15. Mikroobjekt (1) nach Anspruch 13 oder 14, **dadurch gekennzeichnet, dass** der Volumenanteil der Mikropartikel (2) kleiner als 25% ist.

16. Mikroobjekt (1) nach einem der Ansprüche 13 bis 15,
**dadurch gekennzeichnet dass,**
die magnetischen Mikropartikel (2) nach dem vorgegebenen Muster so angeordnet sind, dass die magnetischen Mikropartikel (2) bei Anlegen eines äußeren magnetischen Feldes durch gegenseitige Abstoßung und/oder Anziehung eine Verformung des Mikroobjekts (1) bewirken.

## Claims

1. Method for producing microobjects (1), in which in one method step magnetic microparticles (2) are arranged in a predetermined pattern using a magnetic template (3) and embedded in a matrix (4),
**characterised in that**
a distribution of the magnetic microparticles (2) which is non-homogeneous in the direction of the thickness of the matrix (4) is produced by non-homogeneous stray fields of the magnetic template (3), wherein the predetermined pattern arises as a result of a magnetic domain pattern of the template (3).

2. Method according to claim 1,
**characterised in that**
in a further method step the matrix (4) is detached from the magnetic template (3).

3. Method according to one of the preceding claims,
**characterised in that**
in a further method step the magnetic microparticles (2) are fixed in the matrix (4).

4. Method according to one of the preceding claims,
**characterised in that**
a polymer is used to form the matrix (4).

5. Method according to one of the preceding claims,
**characterised in that**
a matrix material with a modulus of elasticity of less than 2 MPa is used.

6. Method according to one of the preceding claims,
**characterised in that**
the matrix (4) is formed in a thickness of less than 1 mm.

7. Method according to one of the preceding claims,
**characterised in that**
the magnetic microparticles (2) are arranged in a regular pattern.

8. Method according to one of the preceding claims,
**characterised in that**
the magnetic template (3) is not consumed by the method.

9. Method according to one of the preceding claims,
**characterised in that**
the magnetic template (3) is curved.

10. Method according to one of the preceding claims,
**characterised in that**
superparamagnetic microparticles (2) are used.

11. Method according to one of the preceding claims,
**characterised in that**
arrangement of the magnetic microparticles (2) on the magnetic template (3) proceeds in a liquid.

12. Method according to one of the preceding claims,
**characterised in that**
the magnetic microparticles (2) become attached to the template (3) in regions of high magnetic stray field density.

13. Microobject (1) produced according to the method of claim 1, with a matrix (3) in which magnetic microparticles (2) are embedded in a predetermined pattern,
**characterised in that**
the matrix (3) is curved when no external forces are acting on the microobject (1).

14. Microobject (1) according to claim 13,
**characterised in that**
the modulus of elasticity of the matrix (3) is less than 2 MPa.

15. Microobject (1) according to claim 13 or 14,
**characterised in that**
the proportion by volume of the microparticles (2) is less than 25%.

16. Microobject (1) according to one of claims 13 to 15,
**characterised in that**
the magnetic microparticles (2) are arranged in the predetermined pattern in such a way that, on application of an external magnetic field, the magnetic microparticles (2) bring about deformation of the microobject (1) by mutual repulsion and/or attraction.

## Revendications

1. Procédé de fabrication de micro-objets (1), dans lequel des microparticules (2) magnétiques sont agencées, au cours d'une étape du procédé, par un schéma type magnétique (3) selon un modèle prédéterminé, et incorporées dans une matrice (4),
**caractérisé en ce qu'**
une répartition des microparticules (2) magnétiques, inhomogène dans le sens de l'épaisseur de la matrice (4), est générée par des champs de dispersion inhomogènes du schéma type magnétique (3), le modèle prédéterminé apparaissant par un modèle de domaine magnétique du schéma type (3).

2. Procédé selon la revendication 1,
**caractérisé en ce que,**
dans une autre étape du procédé, la matrice (4) est détachée du schéma type magnétique (3).

3. Procédé selon l'une quelconque des revendications précédentes,
**caractérisé en ce que,**
dans une autre étape du procédé, les microparticules (2) magnétiques sont fixées dans la matrice (4).

4. Procédé selon l'une quelconque des revendications précédentes,
**caractérisé en ce qu'**
est utilisé un polymère pour former la matrice (4).

5. Procédé selon l'une quelconque des revendications précédentes,
**caractérisé en ce qu'**
est utilisé un matériau de matrice possédant un module d'élasticité inférieur à 2 MPa.

6. Procédé selon l'une quelconque des revendications précédentes,
**caractérisé en ce que**
la matrice (4) est formée avec une épaisseur de moins de 1 mm.

7. Procédé selon l'une quelconque des revendications précédentes,
**caractérisé en ce que**
les microparticules (2) magnétiques sont agencées dans un modèle régulier.

8. Procédé selon l'une quelconque des revendications précédentes,
**caractérisé en ce que**
le schéma type magnétique (3) n'est pas épuisé par le procédé.

9. Procédé selon l'une quelconque des revendications précédentes,
**caractérisé en ce que**
le schéma type magnétique (3) est bombé.

10. Procédé selon l'une quelconque des revendications précédentes,
**caractérisé en ce que**
sont utilisées des microparticules (2) superparamagnétiques.

11. Procédé selon l'une quelconque des revendications précédentes,
**caractérisé en ce que**
l'agencement des microparticules (2) magnétiques sur le schéma type magnétique (3) s'effectue dans un liquide.

12. Procédé selon l'une quelconque des revendications précédentes,
**caractérisé en ce que**
les microparticules (2) magnétiques se fixent sur le schéma type (3) dans les zones à densité de champ de dispersion magnétique élevée.

13. Micro-objet (1) fabriqué selon le procédé de la revendication 1 doté d'une matrice (3) dans laquelle sont incorporées des microparticules (2) magnétiques selon un modèle prédéterminé,
**caractérisé en ce que**
la matrice (3) est bombée lorsqu'aucune force extérieure n'agit sur le micro-objet (1).

14. Micro-objet (1) selon la revendication 13, **caractérisé en ce que** le module d'élasticité de la matrice (3) est inférieur à 2 MPa.

15. Micro-objet (1) selon la revendication 13 ou 14, **caractérisé en ce que** la fraction volumique des microparticules (2) est inférieure à 25 %.

16. Micro-objet (1) selon l'une quelconque des revendications 13 à 15,
**caractérisé en ce que**
les microparticules (2) magnétiques sont agencées selon le modèle prédéterminé de telle sorte que lesdites microparticules (2) magnétiques entraînent une déformation du micro-objet (1) en créant un champ magnétique extérieur par répulsion et/ou attirance réciproque.
